# EUROPEAN PATENT APPLICATION

(11) **EP 2 573 498 A1**
(43) Date of publication of application: **27.03.2013**
(21) Application number: 10851681.6
(22) Date of filing: 19.05.2010
(51) Int. Cl.: F41A 19/01

(54) **ELECTRIC ENERGY GENERATOR**

(71) Applicant: Delgado Acarreta, Raul, 31500 Tudela (ES)
(72) Inventor: Delgado Acarreta, Raul, 31500 Tudela (ES)
(74) Representative: Pons Ariño, Angel
(86) International application number: PCT/ES2010/070335
(87) International publication number: WO 2011/144768

(57) **Abstract**

The invention relates to an electric energy generator (21 to 23) that transforms a type of mechanical energy into a stable direct current electric energy supply for a shot counter (24) for a portable firearm.

## Description

### FIELD OF THE INVENTION

The present invention relates, in general, to an electric energy generator which supplies electric energy to an electric energy receptor that is configured to perform a count.

### STATE OF THE ART

In the state of the art the use is known of a piezoelectric sensor to determine the number of shots fired with a portable firearm of the short firearm or pistol type.

The piezoelectric sensor delivers an electric signal to a microprocessor when it receives the recoil impulse during the shot.

The microprocessor and the electronic system are supplied from a battery which must periodically be replaced before the end of its useful life.

### DESCRIPTION

The present invention seeks to resolve or reduce one or more of the drawbacks mentioned above by an electric energy generator as defined in the claims.

In an embodiment of the electric energy generator, it is configured to transform one type of energy into an electric energy which can be stably supplied to a counter module of shots fired by a portable firearm.

Consequently, the generator can capture in input terminals one type of energy such as mechanical, acoustic, vibration energy, etc., and, in turn, that said type of energy captured is transmitted to output terminals is transformed into electric energy by an electromechanical transducer arrangement which transforms the mechanical energy in electric energy which is supplied from the output terminals to the shot counter module comprising a microprocessor.

The electric energy generator comprises an electromechanical transducer arrangement configured to be mounted and distributed inside the frame of the portable firearm. The electromechanical transducer arrangement comprises transducers of buzzer type configured to be cantilever-mounted in an electronic circuit card module installed inside the frame of the portable firearm. Furthermore, the buzzer arrangement can be cantilever-mounted in the electronic circuit card module, and said module can be installed inside the grip of the firearm frame. On the other hand, the electromechanical transducer arrangement can be configured to be mounted in a clip of the firearm.

In short, the movements made by the portable firearm, as a reaction to a shot being fired, are captured and transformed into an electric signal which is supplied to the shot counter module.

The electromechanical transducer arrangement comprises a number of transducers depending on the electric energy that it is necessary to supply to the counter module so that it performs said shot counting function.

Consequently, any movement made by the firearm can be transformed into electric energy; however, not all the electric energy supplied to the counter module is sufficient for it to perform the count. In other words, the mechanical energy must be greater than a predetermined threshold value so that on being transformed by the electromechanical transducer arrangement it can generate electric energy of a predetermined voltage and electric current threshold and during a predetermined time interval sufficient so that counter module carries out the task of counting the shot-type events of the portable firearm.

In short, the electronic shot count system can be triggered by a shot-type event or an event other than a shot. However, this latter type of event cannot generate sufficient energy so that the full count process is completed.

The microprocessor is adapted to execute a directrix to establish the number of shots fired with the portable firearm.

### BRIEF DESCRIPTION OF THE FIGURES

A more detailed explanation of devices and/or method in accordance with embodiments of the invention is given in the following description based on the attached figures wherein:
Figure 1 shows an electronic circuit card module with an electromechanical transducer arrangement, and
Figure 2 shows an electric diagram of an electric current energy generator.

### EMBODIMENTS

A portable firearm comprising a grip whereby the shooter grips or holds the firearm whilst firing a shot.

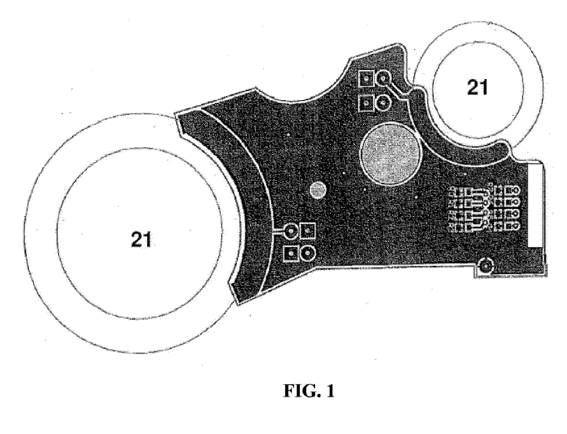

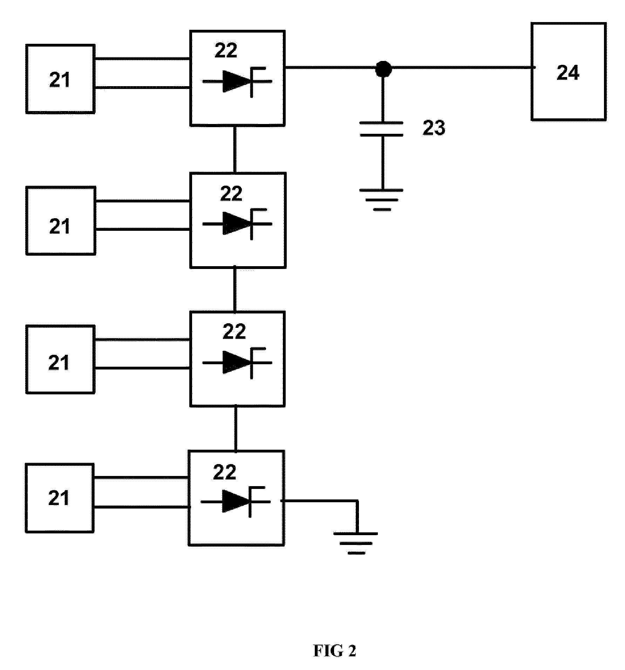

According to figures 1 and 2, the grip comprises plates on both sides of the grip, so that thereunder it is possible to mount an electronic circuit card or board wherein it is possible to mount an electric energy generator comprising an electromechanical transducer (21) arrangement so that a force external thereto causes in the transducer (21) arrangement a displacement in a first element which induces, in turn, a displacement current in a second element and there is an electric field that is supplied to a rectifier means (22) of the complete rectification bridge type.

The transducer arrangement includes at least one electromechanical transducer (21) of buzzer type, pick-up horn, piezoelectric, etc. which captures a sudden variation in mechanical energy regarding a shot-type event and transforms it in electric energy which it supplies through output terminals to the rectification bridge (22) which, in turn, supplies a direct electric current in its output terminals, which are connected to a capacitive storage means (23) of condenser type which provides electric current, at a predetermined voltage value, to a counter module (24) of shots fired by the portable firearm.

The shot counter (24) includes a microprocessor which can be connected to a non-volatile memory to store a count of shot-type events.

The transducer arrangement includes several electromechanical transducers (21) each one of which are connected to their corresponding rectifier bridge (22), which are connected in series with the object of being able to provide sufficient electric current and during a predetermined time interval to the microprocessor so that the latter executes a directrix of shot-type event count.

A rectifier bridge (22) includes four switching elements such as diodes. The output terminals of each rectifier (22) are connected in series and, in turn, to a condenser (23) so that it stores the electric energy supplied by the direct current electric energy generator.

The voltage and electric current that the microprocessor needs to execute a shot count directrix is supplied from the condenser (22).

Now returning to figure 1, the transducer (21) arrangement is cantilever-mounted in the electronic circuit card with the object of making maximum use of the mechanical energy supplied by a shot fired and to reduce the number of electromechanical transducers (21) that are required to supply electric current to the microprocessor through the condenser (23). The transducers (21) distributed in distant points of the electronic circuit card, since as said card is mounted on a grip plate it has an elongated form that substantially follows the form and dimensions of the plate whereon it is mounted.

The meaning of the term cantilever is associated with a mounting of the transducer (21) which allows the maximum possible displacement of the first element of the transducer (21) when a shot-type event occurs, since the portable firearm undergoes a mechanical impulse that must be captured by the transducer (21) arrangement.

In short, the shot counter module (24) is triggered by a shot-type event, the counter not being able to be triggered by an event other than a shot since, in this scenario, the electric energy generator does not generate sufficient electric energy and during the necessary time interval so that the microprocessor performs the shot count, i.e. increases an existing shot count by at least one unit.

If the energy is less, for example, caused by a bump, then the energy generated by the transducer (21) arrangement is insufficient to perform said count cycle, therefore, the microprocessor is incapable of increasing the count by one unit and the non-volatile memory is incapable of storing a numerical value not corresponding to an event other than a shot.

A scenario can be considered wherein the energy received by the transducer (21) arrangement can be such that the generator generates at its output sufficient electric energy to activate the micro but not to continue supplying electric energy during the necessary time interval for the counter to record and store the numerical value of the count in the memory thereof.

Complementary to the aforementioned, the microprocessor executes a control directrix of the data recorded and stored in the memory, to detect and eliminate an account associated to an event other than a shot.

The memory stores the data in the corresponding box of a data matrix, i.e. every time that a shot occurs, the microprocessor records the corresponding matrix, so that the boxes thereof are sequentially filled.

Therefore, at the initial time all the boxes of the memory have a value 0, once the firearm has suffered a series of mechanical impulses, the generator has in turn generated electric energy which, depending thereon the micro has generated a datum which may have been stored in a box of the memory.

In the scenario of an event other than a shot, the generator generates insufficient electric current to complete the recording sequence, i.e. whilst a datum is being recorded the condenser (23) stops supplying electric current; in the corresponding box a voltage value will have been recorded relative to a pseudo datum of a level lower than the voltage value corresponding to the count associated to a shot-type event.

The elimination of the erroneous datum can be performed on extracting or dumping the data stored in the memory to an external device since it needs to supply electric energy complementary to that supplied by the electric energy generator obtained from a shot-type event.

The microprocessor is adapted to execute a count directrix of the shots fired with the portable firearm.

## Claims

1. A direct current electric energy generator, **characterized in that** the generator (21 to 23) comprises an electromechanical transducer (21) arrangement configured to be mounted and distributed through the frame of a portable firearm.

2. A generator according to claim 1, **characterized in that** the generator (21 to 23) comprises an electromechanical transducer (21) arrangement of buzzer type configured to be cantilever-mounted in an electronic circuit card module installed in the frame of the portable firearm.

3. A generator according to claim 1 or 2, **characterized in that** the generator (21 to 23) comprises an arrangement (21) of buzzers configured to be cantilever-mounted in an electronic circuit card module installed inside the grip of the frame of the portable firearm.

4. A generator according to claim 1, **characterized in that** the generator (21 to 23) comprises an arrangement of electromechanical transducers (21) configured to be mounted in a clip of the portable firearm.

5. Generator according to claim 3, **characterized in that** the card module configured to substantially have a form of grip plate, where at each end of said elongated form an electromechanical transducer (21) can be mounted, configured to capture a type of energy, other than electric energy, associated to a shot-type event.

6. Generator according to any of the preceding claims, **characterized in that** the transducer (21) arrangement is configured to transform the energy captured in electric energy and supply it to a rectification module (22).

7. Generator according to claim 6, **characterized in that** the rectification module (22) includes a rectification bridge respectively connected to a transducer (21) of the transducer arrangement, where a rectification bridge can be electrically connected in series to another rectification bridge and the rectification module, in turn, is connected to a capacitive storage module (23).

8. Generator according to claim 6, **characterized in that** the capacitive module (23) can be connected to a counter module (24) of shots fired by a portable firearm.

9. Generator according to claim 6 or 8, **characterized in that** the counter module (24) comprises a microprocessor configured to execute a shot count directrix, in the event that the capacitive module (23) supplies electric current when a shot-type event has occurred.

10. Generator according to claim 9, **characterized in that** the counter module (24) comprises a means of storage connected to the microprocessor and configured to store a count resulting from the execution of the shot count directrix performed by the microprocessor.

11. A portable firearm comprising a grip, **characterized in that** an electric energy generator comprises an electromechanical transducer (21) arrangement configured to be mounted and distributed through the frame of a portable firearm inside an electronic circuit card module installed among the frame of the portable firearm.

12. Firearm according to claim 11, **characterized in that** the electronic circuit card module can be installed between the grip and a plate mounted in the grip of the same firearm.

13. Firearm according to claim 11, **characterized in that** the electric energy generator (21 to 23) supplies electric current to a shot counter module (24) when a shot-type event occurs according to claims 1 to 10.
